(19) Europäisches Patentamt
European Patent Office
Office européen des brevets

(11) **EP 1 960 797 B1**

(12) **EUROPÄISCHE PATENTSCHRIFT**

(45) Veröffentlichungstag und Bekanntmachung des Hinweises auf die Patenterteilung:
**04.03.2009 Patentblatt 2009/10**

(21) Anmeldenummer: **06818604.8**

(22) Anmeldetag: **16.11.2006**

(51) Int Cl.:
***G01R 29/26*** (2006.01)    ***G01R 27/28*** (2006.01)

(86) Internationale Anmeldenummer:
**PCT/EP2006/011019**

(87) Internationale Veröffentlichungsnummer:
**WO 2007/068323 (21.06.2007 Gazette 2007/25)**

(54) **VERFAHREN ZUR MESSUNG DER RAUSCHZAHL EINES MESSOBJEKTS MIT EINEM NETZWERKANALYSATOR**

METHOD FOR MEASURING THE NOISE FACTOR OF A DEVICE UNDER TEST BY MEANS OF A NETWORK ANALYZER

PROCEDE DE MESURE DU COEFFICIENT DE BRUIT D'UN OBJET DE MESURE AU MOYEN D'UN ANALYSEUR DE RESEAU

(84) Benannte Vertragsstaaten:
**DE FR GB**

(30) Priorität: **14.12.2005 DE 102005059791**

(43) Veröffentlichungstag der Anmeldung:
**27.08.2008 Patentblatt 2008/35**

(73) Patentinhaber: **Rohde & Schwarz GmbH & Co. KG**
**81671 München (DE)**

(72) Erfinder: **HELD, Werner**
**94060 Pocking (DE)**

(74) Vertreter: **Körfer, Thomas**
**Mitscherlich & Partner**
**Patent- und Rechtsanwälte**
**Sonnenstrasse 33**
**80331 München (DE)**

(56) Entgegenhaltungen:
**EP-A- 0 874 245**        **EP-A- 1 139 107**
**WO-A-00/25142**        **DE-A1- 4 122 189**
**DE-A1- 10 302 362**        **US-A- 5 191 294**

• **SINCLAIR M W: "NOISE MEASUREMENTS" MICROWAVE MEASUREMENTS, 1989, Seiten 176-208, XP001153844**

## Beschreibung

Die Erfindung betrifft ein Verfahren zur Messung der Rauschzahl eines Objekts mit einem Netzwerkanalysator.

Zu den wichtigsten elektrischen Kenndaten eines Meßobjekts (device-under-test=DUT) gehören die S-Parameter und das Rauschmaß. Die Messung des Rauschmaßes wird im allgemeinen mit einer Rauschquelle und einem Spektrumanalysator ermittelt. Zur Bestimmung der S-Parameter verwendet man üblicherweise einen Netzwerkanalysator.

Ein Verfahren und eine Vorrichtung zum Bestimmen der Rauschzahl von elektronischen Messobjekten ist z. B. aus der DE 103 02 362 A1 bekannt.

Zur Ermittlung der Rauschzahl eines Meßobjekts ist auch, wie weiter unten im Detail noch gezeigt wird, die von der S-Parametern abhängige Leistungsverstärkung des Meßobjekts erforderlich. Somit benötigt man zur Messung der Rauschzahl eines Meßobjekts nachteilig sowohl einen Netzwerkanalysator zur Bestimmung der S-Parameter für die Leistungsverstärkung des Meßobjekts als auch einen Spektrumanalysator zur Messung der für die Ermittlung der Rauschzahl zusätzlich erforderlichen Ausgangsrauschleistung des Meßobjekts.

WO 00/25142 A und US 5 191 294 A beschreiben weitere Verfahren zur Rauschzahl-Messung.

Aufgabe der Erfindung ist es deshalb, ein Verfahren zur Ermittlung der Rauschzahl eines Meßobjekts zu entwickeln, das eine reduzierte Anzahl von Meßgeräten benötigt.

Die Aufgable wird durch ein Verfahren nach dem Anspruch 1 gelöst.

Erfindungsgemäß wird hierzu einzig ein Netzwerkanalysator verwendet, der nach dem Stand der Technik über eine Eingangsempfindlichkeit verfügt, die der Eingangsempfindlichkeit eines Spektrumanalysators entspricht und damit für die Messung der Rauschleistung geeignet ist. Mit einem derartigen Netzwerkanalysator lassen sich sowohl die S-Parameter des Meßobjekts zur Bestimmung der zugehörigen Leistungsverstärkung, als auch die Ausgangsrauschleistung an einem der beiden Tore des Meßobjekts, die jeweils mit einem Tor (Port) des Netzwerkanalysators verbunden sind, ohne Anregung des Meßobjekts mit einem von einer Rauschquelle erzeugten Rauschsignal messen und ohne den Meßaufbau im wesentlichen zu ändern.

Die Eingangsimpedanz des messenden Ports des Netzwerkanalysators ist in der Regel mit einem 50 Ω Widerstand angepaßt. Im Falle einer Fehlanpassung der Eingangsimpedanz des messenden Tors des Netzwerkanalysators ist die gemessene Ausgangsrauschleistung mit einem Fehlanpassungsfaktor zu korrigieren.

Eine Ungenauigkeit zwischen dem korrekten Meßwert der am zu messenden Tors des Meßobjekts anliegenden Ausgangsrauschleistung und dem tatsächlich gemessenen, unkorrekten Meßwert der am zu messenden Tor des Meßobjekts anliegenden Ausgangsrauschleistung und das Eigenrauschen des Netzwerkanalysators ist im Rahmen eines Kalibriervorgangs durch Anregung des messenden Tors des Netzwerkanalysators mit dem Rauschen einer mit dem Netzwerkanalysator gekoppelten, eingeschalteten und anschließend ausgeschalteten Rauschquelle zu ermitteln.

Eine Ausführungsform des erfindungsgemäßen Verfahrens zur Messung der Rauschzahl eines Meßobjekts mit einem Netzwerkanalysator wird im folgenden im Detail anhand der Zeichnung erläutert. Die Figuren der Zeichnung zeigen:

Fig. 1    ein Flußdiagramm eines Verfahrens zur Messung der Rauschzahl eines Meßobjekts mit einem Netzwerkanalysator,

Fig. 2    ein Blockschaltbild einer Anordnung zur Durchführung des Kalibriervorgangs des Netzwerkanalysators und

Fig. 3    ein Blockschaltbild einer Anordnung zur Durchführung des Meßvorgangs der Rauschzahlmessung mit einem Netzwerkanalysator.

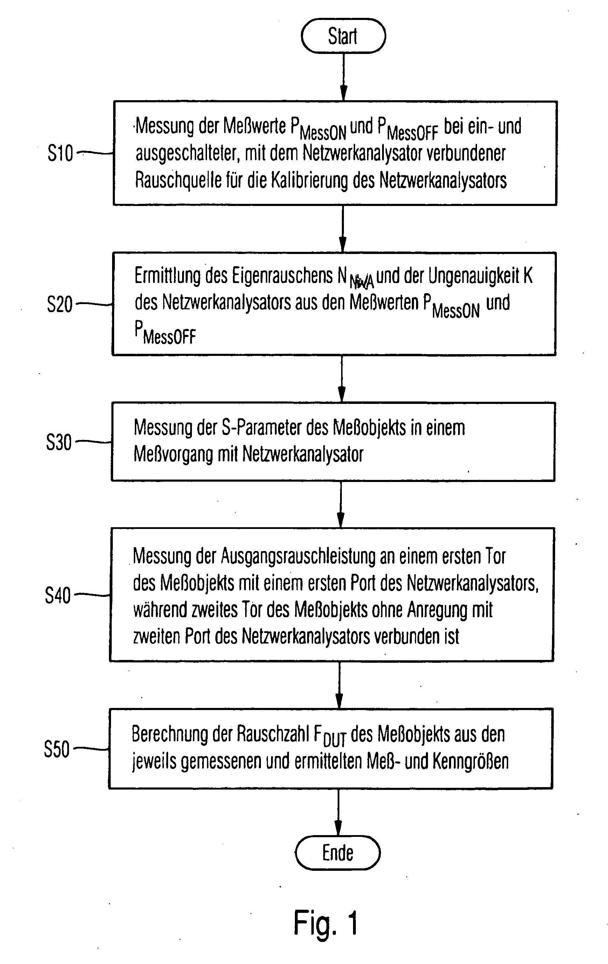

Bevor anhand der Fig. 1 bis 3 das erfindungsgemäße Verfahren zur Messung der Rauschzahl eines Meßobjekts mit einem Netzwerkanalysator (NWA) im Detail erläutert wird, werden im folgenden die mathematischen Zusammenhänge beschrieben, die für das Verständnis des erfindungsgemäßen Verfahrens erforderlich sind.

Die Rauschzahl $F_{DUT}$, eines Meßobjekts ist als Verhältnis der gesamten Ausgangsrauschleistung $N_{OUT}$ am Ausgang eines Meßobjekts zur Ausgangsrauschleistung $N_{OUT}'$ am Ausgang des Meßobjekts definiert, welche einzig aus der am Eingang des Meßobjekts anliegenden Rauschleistung resultiert. Die gesamte Ausgangsrauschleistung $N_{OUT}$ am Ausgang des Meßobjekts ergibt sich gemäß Gleichung (1) aus der mit der Leistungsverstärkung $G_{DUT}$ des Meßobjekts verstärkten "Rauschleistungssumme" aus der vom Meßobjekt selbst erzeugten Rauschleistung $N_{DUT}$ und dem bei angepaßter Meßschaltung stets vorhandenen thermischen Rauschen $N_0$ eines 50Ω-Widerstand-Systems bei einer Raumtemperatur von 290 K.

$$N_{OUT} = (N_{DUT} + N_0) \cdot G_{DUT} \qquad\qquad (1)$$

Die Ausgangsrauschleistung am Ausgang des Meßobjekts $N_{OUT}'$, die einzig aus der am Eingang des Meßobjekts anliegenden Rauschleistung resultiert, entspricht bei einem Meßobjekt, dessen Eingang nicht von einer Rauschquelle angeregt wird, gemäß Gleichung (2) dem mit der Leistungsverstärkung $G_{DUT}$ des Meßobjekts verstärkten Temperaturrauschen $N_0$ eines 50$\Omega$-Widerstands-System bei einer Raumtemperatur von 290 K.

$$N_{OUT}' = N_0 \cdot G_{DUT} \qquad\qquad (2)$$

Somit ergibt sich die Rauschzahl $F_{DUT}$ gemäß Gleichung (3):

$$F_{DUT} = \frac{N_{OUT}}{N_{OUT}'} = \frac{N_{DUT} + N_0}{N_0} \qquad\qquad (3)$$

Das Rauschmaß $NF_{DUT}$ eines Meßobjekts stellt gemäß Gleichung (4) die logarithmierte Rauschzahl $F_{DUT}$ des Meßobjekts dar.

$$NF_{DUT} = 10 \cdot \log\left(F_{DUT}\right) \qquad\qquad (4)$$

Der vom Netzwerkanalysator zu messende Meßwert $P_{NOISE}$ der Ausgangsrauschleistung $N_{OUT}$ des Meßobjekts ist gemäß Gleichung (5) vom Eigenrauschen $N_{NWA}$ des Netzwerkanalysator überlagert.

$$P_{NOISE} = N_{NWA} + N_{OUT} \qquad\qquad (5)$$

Faßt man die Gleichungen (1), (3) und (5) zusammen, so ergibt sich die in Gleichung (6) enthaltene Formel zur Ermittlung der Rauschzahl $F_{DUT}$.

$$F_{DUT} = \frac{P_{NOISE} - N_{NWA}}{G_{DUT} \cdot N_0} \qquad\qquad (6)$$

Die Leistungsverstärkung $G_{DUT}$ des Meßobjekts ergibt sich bei einem 50$\Omega$-System aus dem Vorwärtsübertragungsfaktor $S_{21}$ des Meßobjekts gemäß Gleichung (7):

$$G_{DUT} = \left|S_{21}\right|^2 \qquad\qquad (7)$$

Falls die Eingangsimpedanz des Netzwerkanalysators aufgrund einer Fehlanpassung nicht den Wert 50 $\Omega$ aufweist, ist die Leistungsverstärkung $G_{DUT}$ mit einem Fehlanpassungsfaktor $M$ gemäß Gleichung (8) zu multiplizieren, wobei hierbei $\Gamma_{NWA}$ der Eingangsreflexionsfaktor des Netzwerkanalysators und $S_{22}$ der Ausgangsreflexionsfaktor des Meßobjektsist.

$$M = \frac{1 - \left|\Gamma_{NWA}\right|^2}{\left|1 - S_{22} \cdot \Gamma_{NWA}\right|^2} \tag{8}$$

Das thermische Rauschen $N_0$ eines 50$\Omega$-Widerstand-Systems ergibt sich aus der Raumtemperatur $T$ von 290 K und der Boltzmannkonstante $k$ gemäß Gleichung (9) zu $4 \cdot 10^{-21} \frac{W}{HZ} = -174 \frac{dB_m}{Hz}$ .

$$N_0 = k \cdot T = 4 \cdot 10^{-21} \frac{W}{HZ} = -174 \frac{dB_m}{Hz} \tag{9}$$

Das Eigenrauschen $N_{NWA}$ des Netzwerkanalysators, das sich der Ausgangsrauschleistung $N_{OUT}$ des Meßobjekts additiv überlagert, und eine Ungenauigkeit $k$ des Netzwerkanalysators, die sich gemäß Gleichung (10) dem korrekten Meßwert $P_{NOISE}$ multiplikativ überlagert und zu einem unkorrekten Meßwert $P_{MESS}$ führt, werden in einen Kalibriervorgang des Netzwerkanalysators ermittelt.

$$P_{Mess} = k \cdot P_{NOISE} \tag{10}$$

Hierzu wird das messende Tor (Port) des Netzwerkanalysators mit einer ausgeschalteten Rauschquelle verbunden. Der zum korrekten Meßwert $P_{NOISEOFF}$ korrespondierende unkorrekt ermittelte Meßwert $P_{MessOFF}$ am Port des Netzwerkanalysators ergibt sich bei ausgeschalteter Rauschquelle gemäß Gleichung (11) aus dem Eigenrauschen $N_{NWA}$ des Netzwerkanalysators und dem thermischen Rauschen $N_0$ eines 50$\Omega$-Widerstand-Systems bei Raumtemperatur von 290 K im Fall einer angepaßten Meßschaltung.

$$P_{MessOFF} = k \cdot P_{NOISEOFF} = k \cdot \left(N_{NWA} + N_0\right) \tag{11}$$

Entsprechend ergibt sich der zum korrekten Meßwert $P_{NOISEON}$ korrespondierende unkorrekt ermittelte Meßwert $P_{MessON}$ bei eingeschalteter Rauschquelle gemäß Gleichung (12) aus dem Eigenrauschen $N_{NWA}$ des Netzwerkanalysators, dem thermischen Rauschen $N_0$ eines 50$\Omega$-Widerstand-Systems bei Raumtemperatur von 290 K in einem Frequenzbereich von 1 Hz im Fall einer angepaßten Meßschaltung und dem Zusatzrauschen $N_{NS}$ der Rauschquelle.

$$P_{MessON} = k \cdot P_{NOISEON} = k \cdot \left(N_{NWA} + N_0 + N_{NS}\right) \tag{12}$$

Das Zusatzrauschen $N_{NS}$ der Rauschquelle kann gemäß Gleichung (13) aus dem vom Hersteller der Rauschquelle angegebenen ENR-Faktor (Excess-Noise-Ratio), der das Verhältnis des Zusatzrauschens der Rauschquelle zum thermischen Rauschen $N_0$ eines 50$\Omega$-Widerstand-Systems bei Raumtemperatur von 290 K angibt, bestimmt werden.

$$N_{NS} = 10^{\frac{ENR}{10}} \cdot N_0 \tag{13}$$

Aus den Gleichungen (11) bis (13) ergibt sich durch mathematische Umformung die Ungenauigkeit $k$ gemäß Gleichung (14) und das Eigenrauschen $N_{NWA}$ des Netzwerkanalysators gemäß Gleichung (15).

$$k = \frac{P_{MessON} - P_{MessOFF}}{10^{\frac{ENR}{10}} \cdot N_0} \qquad (14)$$

$$N_{NWA} = \frac{P_{MessOFF}}{k} - N_0 \qquad (15)$$

Ausgehend von Gleichung (6) ergibt sich mit der gemäß Gleichung (14) berechneten Ungenauigkeit $k$ unter Berücksichtigung von Gleichung (10) die Rauschzahl $F_{DUT}$ für ein zu vermessendes Meßobjekt gemäß Gleichung (16) aus dem unkorrekt gemessenen Meßwert $P_{Mess}$ der Ausgangsrauschleistung $N_{OUT}$ des Meßobjekts:

$$F_{DUT} = \frac{\dfrac{P_{Mess}}{k} - N_{NWA}}{G_{DUT} \cdot N_0} \qquad (16)$$

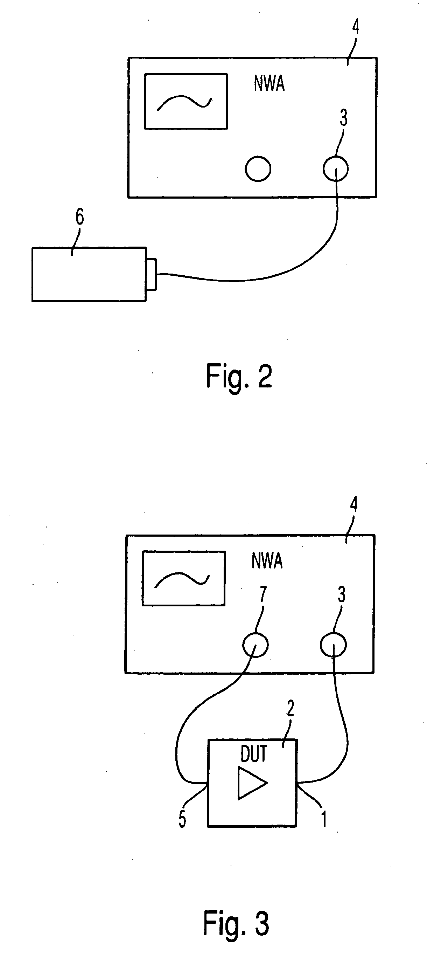

Das erfindungsgemäße Verfahren zur Messung der Rauschzahl eines Meßobjekts mit einem Netzwerkanalysator beginnt mit der Kalibrierung des Netzwerkanalysators. Hierzu wird in einer Kalibrierungsanordnung gemäß Fig. 2 die zu messende Rauschleistung einer Rauschquelle mit dem ersten messenden Tor (Port) 3 des Netzwerkanalysators (NWA) 4 verbunden. Während der Durchführung des erfindungsgemäßen Verfahrens zur Messung der Rauschzahl wird die Anordnung bei einer konstanten Raumtemperatur $T$ von 290 K betrieben und das zu erfassende Rauschleistungsspektrum mit einer gewissen Meßbandbreite des Netzwerkanalysators 4 gemessen, um ein Temperaturrauschen $N_0$ der angepaßten Meßschaltung, das einem 50Ω-Widerstands-System entspricht, beim standardisierten Normwert -

$-174 \dfrac{dB_m}{Hz}$ - zu erhalten.

Im ersten Verfahrensschritt S10 des erfindungsgemäßen Verfahrens zur Messung der Rauschzahl eines Meßobjekts mit einem Netzwerkanalysator wird bei ausgeschalteter Rauschquelle 6 der Meßwert $P_{MessOFF}$ am ersten messenden Tor (Port) 3 des Netzwerkanalysators 4 gemäß Gleichung (11) gemessen. Analog wird bei eingeschalteter Rauschquelle 6 der Meßwert $P_{MessON}$ am ersten messenden Tor (Port) 4 des Netzwerkanalysators 3 gemäß Gleichung (12) gemessen.

Mit den beiden gemessenen und zwischengespeicherten Meßwerten $P_{MessOFF}$ und $P_{MessON}$ wird im nächsten Verfahrensschritt S20 die Ungenauigkeit $k$ und das Eigenrauschen $N_{NWA}$ des Netzwerkanalysators 4 gemäß der Gleichungen (14) und (15) berechnet und zwischengespeichert.

Anschließend wird die Kalibrierungsanordnung in eine Meßanordnung gemäß Fig. 3 umgebaut, in der das zweite Tor 5 des Meßobjekts 2 mit dem zweiten Tor (Port) 7 des Netzwerkanalysators 4 verbunden wird.

In dieser Meßanordnung gemäß Fig. 3 werden die einzelnen S-Parameter des Meßobjekts 2 mit dem Netzwerkanalysator 4 nach bekannten Verfahren in Verfahrensschritt S30 ermittelt und aus dem gemessenen Vorwärtsübertragungsfaktor $S_{21}$ die Leistungsverstärkung $G_{DUT}$ des Meßobjekts 2 gemäß Gleichung (7) bestimmt und zwischengespeichert. Falls der Eingangsimpedanz am ersten Tor (Port) 3 des Netzwerkanalysators 4 nicht auf den Wert 50 Ω angepaßt ist, wird der Ausgangsreflexionsfaktor $S_{22}$ des Meßobjekts 2 mit einem Fehlanpassungsfaktor M gemäß Gleichung (8) multipliziert, um auf diese Weise eine Anpassung der Meßanordnung zu erzielen.

Während das mit dem zweiten Tor (Port) 7 des Netzwerkanalysators 4 verbundene zweite Tor 5 des Meßobjekts 2 vom Netzwerkanalysator 4 nicht mit einem Generatorsignal in Form eines Rauschsignals angeregt wird, wird in Verfahrensschritt S40 am ersten Tor (Port) 3 des Netzwerkanalysators 4 der Meßwert $P_{Mess}$ der am ersten Tor (Port) 1 des Meßobjekts 2 anliegenden Ausgangsrauschleistung gemessen.

Mit dem im vorherigen Verfahrensschritt S40 ermittelten Meßwert $P_{Mess}$ der am ersten Tor (Port) 1 des Meßobjekts 2 anliegenden Ausgangsrauschleistung, dem in Verfahrensschritt S30 bestimmten Leistungsverstärkung $G_{DUT}$ des Meßobjekts 2, den beiden in den Verfahrensschritten S10 und S20 ermittelten und berechneten Kenngrössen - Ungenauigkeit $k$ und Eigenrauschen $N_{NWA}$ - des Netzwerkanalysators 4 und der standardisierten Kenngrösse des thermischen Rauschens $N_0$ eines 50Ω-Widerstand-Systems wird in dem abschließenden Verfahrensschritt S50 die Rauschzahl $F_{DUT}$ gemäß Gleichung (16) berechnet.

**Patentansprüche**

1. Verfahren zur Messung der Rauschzahl ($F_{DUT}$) eines Messobjekts (2) einzig mit einem Netzwerkanalysator (4) enthaltend folgende Verfahrensschritte:

   • Ermitteln der Ungenauigkeit ($k$) und des Eigenrauschen ($N_{NWA}$) des Netzwerkanalysators (4) aus den in einem Kalibriervorgang bei ausgeschalteter Rauschquelle (6) am ersten messenden, mit der Rauschquelle (6) verbundenen Tor (3) des Netzwerkanalysators (4) gemessenen Messwert ($P_{MessOff}$) und bei eingeschalteter Rauschquelle (6) am ersten, messenden, mit der Rauschquelle (6) verbundenen Tor (3) des Netzwerkanalysators (4) gemessenen Messwert ($P_{MessOn}$) ;
   • Bestimmen der Leistungsverstärkung ($G_{DUT}$) durch Messung der S-Parameter des Messobjekts (2) aus dem gemessenen Vorwärtsübertragungsfaktors ($S_{21}$) des Messobjekts (2), dessen erstes Tor (1) mit dem ersten Tor (3) des Netzwerkanalysators (4) und dessen zweites Tor (5) mit dem zweiten Tor (7) des Netzwerkanalysators (4) verbunden ist;
   • Messen eines Messwerts ($P_{Mess}$) der am ersten Tor. (1) des Messobjekts (2) anliegenden Ausgangsrauschleistung am ersten Tor (3) des Netzwerkanalysators (4), während das mit dem zweiten Tor (7) des Netzwerkanalysators (4) verbundene zweite Tor (5) des Messobjekts (2) vom Netzwerkanalysators (4) nicht mit einem Generatorsignal in Form eines Rauschsignals angeregt wird und
   • Berechnen der Rauschzahl ($F_{DUT}$) aus dem Messwert ($P_{Mess}$) der Ausgangsrauschleistung, der Leistungsverstärkung ($G_{DUT}$) des Meßobjekts (2), der Ungenauigkeit ($k$) und des Eigenrauschens ($N_{NWA}$) des Netzwerkanalysators (4) und des thermischen Rauschens ($N_0$) eines 50Ω-Widerstands-Systems.

2. Verfahren zur Messung der Rauschzahl eines Messobjekts nach Anspruch 1,
   **dadurch gekennzeichnet,**
   **dass** die Eingangsimpedanz des die am ersten Tor (1) des Messobjekts (2) anliegenden Ausgangsrauschleistung messenden ersten Tors (3) des Netzwerkanalysators (4) 50 Ω bei einer Raumtemperatur von 290 K beträgt.

3. Verfahren zur Messung der Rauschzahl eines Messobjekts nach Anspruch 1 oder 2,
   **dadurch gekennzeichnet,**
   **dass** sich die Rauschzahl $F_{DUT}$ des Messobjekts (2) nach folgender Formel berechnet:

$$F_{DUT} = \frac{P_{NOISE} - N_{NWA}}{G_{DUT} \cdot N_0}$$

   wobei

   $P_{NOISE}$ der vom Netzwerkanalysator zu messende Messwert der Ausgangsrauschleistung,
   $N_{NWA}$ das Eigenrauschen des Netzwerkanalysators,
   $G_{DUT}$ die Leistungsverstärkung des Messobjekts und
   $N_0$ das thermische Rauschen eines 50Ω-Widerstands bei einer Raumtemperatur von 290 K

   sinn.

4. Verfahren zur Messung der Rauschzahl eines Messobjekts nach einem der Ansprüche 1 bis 3,
   **dadurch gekennzeichnet,**
   **dass** im Fall einer Fehlanpassung der Eingangsimpedanz des die am ersten Tor (1) des Messobjekts (2) anliegende Ausgangsrauschleistung messenden ersten Tors (3) der am ersten Tor (3) des Netzwerkanalysators (4) gemessene Ausgangsreflexionsfaktor $S_{22}$ mit dem Fehlanpassungsfaktor $M$ multipliziert wird, der sich nach folgender Formel berechnet:

$$M = \frac{1 - \left|\Gamma_{NWA}\right|^2}{\left|1 - S_{22} \cdot \Gamma_{NWA}\right|^2}$$

wobei

$\Gamma_{NWA}$ der Eingangsreflexionsfaktor des Netzwerkanalysators ist.

5. Verfahren zur Messung der Rauschzahl eines Messobjekts nach einem der Ansprüche 1 bis 4,
**dadurch gekennzeichnet,**
**dass** der am ersten Tor (3) des Netzwerkanalysators (4) zu ermittelnde Messwert $P_{NOISE}$ der am ersten Tor (1) des Messobjekts (2) anliegenden Augangsrauschleistung durch Division des vom Netzwerkanalysator (4) unkorrekt gemessenen Meßwerts $P_{Mess}$ der am ersten Tor (1) des Messobjekts (3) anliegenden Ausgangsrauschleistung mit einer durch Kalibrierung ermittelten Ungenauigkeit $k$ des Netzwerkanalysators (4) gemäß folgender mathematischer Beziehung berechnet wird:

$$P_{NOISE} = \frac{P_{Mess}}{k}$$

6. Verfahren zur Messung der Rauschzahl eines Messobjekts nach Anspruch 5,
**dadurch gekennzeichnet,**
**dass** sich der am ersten Tor (3) des Netzwerkanalysators (4) unkorrekt gemessene Messwert $P_{MessOFF}$ der am ersten Tor (1) des Messobjekts (2) anliegenden Ausgangsrauschleistung in dem Kalibriervorgang mit der ausgeschalteten und mit dem ersten Tor (3) des Netzwerkanalysators (4) verbundene Rauschquelle (6) nach folgender Formel berechnet:

$$P_{MessOFF} = k \cdot (N_{NWA} + N_0) ,$$

wobei

$N_0$ das thermische Rauschen des 50$\Omega$-Widerstands bei einer Raumtemperatur von 290 K und
$k$ die Ungenauigkeit des Netzwerkanalysators (4)

sind.

7. Verfahren zur Messung der Rauschzahl eines Messobjekts nach Anspruch 6,
**dadurch gekennzeichnet,**
**dass** sich der am ersten Tor (3) des Netzwerkanalysators (4) unkorrekt gemessener Messwert $P_{MessON}$ der am ersten Tor (1) des Messobjekts (2) anliegenden Ausgangsrauschleistung in dem Kalibriervorgang mit der eingeschalteten und mit dem ersten Tor (3) des Netzwerkanalysators (4) verbundener Rauschquelle (6) nach folgender Formel berechnet:

$$P_{MessON} = N_{NS} + N_{NWA} + N_0 = 10^{\frac{ENR}{10}} \cdot N_0 + N_{NWA} + N_0 .$$

wobei

$N_{NS}$ das Zusatzrauschen der Rauschquelle und
$ENR$ das Verhältnis des Zusatzrauschen der Rauschquelle zum thermischen Rauschen $N_0$ des 50Ω-Widerstands bei 290 K Raumtemperatur

sind.

8. Verfahren zur Messung der Rauschzahl eines Messobjekts nach Anspruch 7,
**dadurch gekennzeichnet,**
**dass** sich die Ungenauigkeit ($k$) des Netzwerkanalysators (4) nach folgender Formel berechnet :

$$k = \frac{P_{MessON} - P_{MessOFF}}{10^{\frac{ENR}{10}} \cdot N_0} \cdot$$

9. Verfahren zur Messung der Rauschzahl eines Messobjekts nach Anspruch 8,
**dadurch gekennzeichnet,**
**dass** sich das Eigenrauschen $N_{NWA}$ des Netzwerkanalysators (4) nach folgender Formel berechnet:

$$N_{NWA} = \frac{P_{MessOFF}}{k} - N_0 \cdot$$

## Claims

1. Method for measuring the noise figure ($F_{DUT}$) of a device under test (2) using only a network analyser (4) comprising the following procedural stages:

   - determination of the inaccuracy ($k$) and the internal noise ($N_{NWA}$) of the network analyser (4) in a calibration process from the measured value ($P_{MessOFF}$) measured with the noise source (6) switched off at the first measuring port (3) of the network analyser (4) connected to the noise source (6), and from the measured value ($P_{MessON}$) with the noise source (6) switched on at the first measuring port (3) of the network analyser (4) connected to the noise source (6);
   - determination of the power amplification ($G_{DUT}$) by measurement of the S-parameters of the device under test (2) from the measured forward-transmission factor $S_{21}$, of the device under test (2), of which the first port (1) is connected to the first port (3) of the network analyser (4) and of which the second port (5) is connected to the second port (7) of the network analyser (4);
   - measurement of a measured value ($P_{Mess}$) of the output noise power applied to the first port (1) of the device under test (2) at the first port (3) of the network analyser (4), while the second port (5) of the device under test (2) connected to the second port (7) of the network analyser (4) is not excited by the network analyser (4) with a generator signal in the form of a noise signal; and
   - calculation of the noise figure ($F_{DUT}$) from the measured value ($P_{Mess}$) of the output noise power, the power amplification ($G_{DUT}$) of the device under test (2), the inaccuracy ($k$) and the internal noise ($N_{NWA}$) of the network analyser (4) and the thermal noise ($N_0$) of a 50 Ω resistor system.

2. Method for measuring the noise figure of a device under test according to claim 1,
**characterised in that**
the input impedance of the first port (3) of the network analyser (4) measuring the output noise power applied at the first port (1) of the device under test (2) is 50 Ω at a room temperature of 290 K.

3. Method for measuring the noise figure of a device under test according to claim 1 or 2,
**characterised in that**
the noise figure $F_{DUT}$ of the device under test (2) is calculated according to the following formula:

$$F_{DUT} = \frac{P_{NOISE} - N_{NWA}}{G_{DUT} \cdot N_0}$$

wherein

$P_{NOISE}$ denotes the measured value of the output noise power to be measured by the network analyser;
$N_{NWA}$ denotes the internal noise of the network analyser;
$G_{DUT}$ denotes the power amplification of the device under test; and
$N_0$ denotes the thermal noise of a 50-Ω resistor at a room temperature of 290 K.

**4.** Method for measuring the noise figure of a device under test according to any one of claims 1 to 3, **characterised in that**,
in the case of an error-matching of the input impedance of the first port (3) measuring the output noise power applied at the first port (1) of the device under test (2), the output-reflection coefficient $S_{22}$ measured at the first port (3) of the network analyser (4) is multiplied by the error-matching factor $M$, which is calculated according to the following formula:

$$M = \frac{1 - \left|\Gamma_{NWA}\right|^2}{\left|1 - S_{22} \cdot \Gamma_{NWA}\right|^2}$$

wherein

$\Gamma_{NWA}$ denotes the input-reflection coefficient of the network analyser.

**5.** Method for measuring the noise figure of a device under test according to any one of claims 1 to 4, **characterised in that**
the measured value $P_{NOISE}$ of the output noise power applied at the first port (1) of the device under test (2) to be determined at the first port (3) of the network analyser (4) is calculated by dividing the measured value $P_{Mess}$ of the output noise power applied at the first port (1) of the device under test (3), incorrectly measured by the network analyser (4), by an inaccuracy $k$ of the network analyser (4) determined by calibration according to the following mathematical relationship:

$$P_{NOISE} = \frac{P_{Mess}}{k} \ .$$

**6.** Method for measuring the noise figure of a device under test according to claim 5, **characterised in that**
the measured value $P_{MessOFF}$ of the output noise power applied at the first port (1) of the device under test (2), incorrectly measured at the first port (3) of the network analyser (4), is calculated in the calibration process with the noise source (6) switched off and connected to the first port (3) of the network analyser (4) according to the following formula:

$$P_{MessOFF} = k \cdot (N_{NWA} + N_0) \ ,$$

wherein

$N_0$ denotes the thermal noise of the 50-Ω resistor at a room temperature of 290 K; and

*k* denotes the inaccuracy of the network analyser (4).

7. Method for measuring the noise figure of a device under test according to claim 6, **characterised in that** the measured value $P_{MessON}$ of the output noise power applied at the first port (1) of the device under test (2), incorrectly measured at the first port (3) of the network analyser (4), is calculated in the calibration process with the noise source (6) switched on and connected to the first port (3) of the network analyser (4) according to the following formula:

$$P_{MessON} = N_{NS} + N_{NWA} + N_0 = 10^{\frac{ENR}{10}} \cdot N_0 + N_{NWA} + N_0 \, ,$$

wherein

$N_{NS}$ denotes the excess noise of the noise source; and
$ENR$ denotes the ratio of the excess noise of the noise source relative to the thermal noise $N_0$ of the 50-$\Omega$ resistor at 290 K room temperature.

8. Method for measuring the noise figure of a device under test according to claim 7, **characterised in that** the inaccuracy (*k*) of the network analyser (4) is calculated according to the following formula:

$$k = \frac{P_{MessON} - P_{MessOFF}}{10^{\frac{ENR}{10}} \cdot N_0}$$

9. Method for measuring the noise figure of a device under test according to claim 8, **characterised in that** the internal noise $N_{NWA}$ of the network analyser (4) is calculated according to the following formula:

$$N_{NWA} = \frac{P_{MessOFF}}{k} - N_0$$

**Revendications**

1. Procédé de mesure du coefficient de bruit ($F_{DUT}$) d'un objet de mesure uniquement avec un analyseur de réseau (4) comprenant les étapes de procédé suivantes :

- détection de l'imprécision (k) et du bruit propre ($N_{NWA}$) de l'analyseur de réseau (4) à partir de la valeur de mesure ($P_{MessOff}$) mesurée sur le premier port de mesure (3) de l'analyseur de réseau (4), connecté à la source de bruit (6), avec la source de bruit (6) hors circuit, et de la valeur de mesure ($P_{MessOn}$) mesurée sur le premier port de mesure (3) de l'analyseur de réseau (4), connecté à la source de bruit (6), avec la source de bruit (6) en circuit, dans un processus d'étalonnage ;
- détermination de l'amplification de puissance ($G_{DUT}$) par la mesure du paramètre S de l'objet de mesure (2) à partir du facteur de transmission directe ($S_{21}$) de l'objet de mesure (2), dont le premier port (1) est connecté au premier port (3) de l'analyseur de réseau (4) et le deuxième port (5) est connecté au deuxième port (7) de l'analyseur de réseau (4) ;
- mesure, au niveau du premier port (3) de l'analyseur de réseau (4), d'une valeur de mesure ($P_{Mess}$) de la puissance de bruit de sortie présente sur le premier port (1) de l'objet de mesure (2), pendant que deuxième port (5) de l'objet de mesure (2) connecté au deuxième port (7) de l'analyseur de réseau (4) n'est pas excité par l'analyseur de réseau (4) avec un signal de générateur sous forme d'un signal de bruit et
- calcul du coefficient de bruit ($F_{DUT}$) à partir de la valeur de mesure ($P_{Mess}$), de l'amplification de puissance ($G_{DUT}$) de l'objet de mesure (2), de l'imprécision (k) et du bruit propre ($N_{NWA}$) de l'analyseur de réseau (4), et du bruit thermique ($N_0$) d'un système de résistance de 50 Ω.

2. Procédé de mesure du coefficient de bruit d'un objet de mesure selon la revendication 1, **caractérisé en ce que** l'impédance d'entrée du premier port de mesure (3) de l'analyseur de réseau (4) présente sur le premier port (1) de l'objet de mesure (2) est de à 50 Ω pour une température ambiante de 290 K.

3. Procédé de mesure du coefficient de bruit d'un objet de mesure selon la revendication 1 ou 2, **caractérisé en ce que** le coefficient de bruit ($F_{DUT}$) d'un objet de mesure est calculé à partir de la formule suivante :

$$F_{DUT} = \frac{P_{NOISE} - N_{NWA}}{G_{DUT} \cdot N_0}$$

où
$P_{NOISE}$ est la puissance de bruit de sortie de la valeur de mesure à mesurer provenant de l'analyseur de réseau (4),
$N_{NWA}$ est le bruit propre de l'analyseur de réseau,
$G_{DUT}$ est l'amplification de puissance de l'objet de mesure et
$N_0$ est le bruit thermique d'une résistance de 50 Ω pour une température ambiante de 290 K.

4. Procédé de mesure du coefficient de bruit d'un objet de mesure selon l'une des revendications 1 à 3, **caractérisé en ce que**, dans le cas où d'une désadaptation de l'impédance d'entrée du premier port (3) mesurant la puissance de bruit de sortie présente sur le premier port (1) de l'objet de mesure (2), le facteur de réflexion de sortie $S_{22}$ mesuré sur le premier port (3) de l'analyseur de réseau (4) est multiplié par le facteur de désadaptation M, qui est calculé à partir de la formule suivante :

$$M = \frac{1 - |\Gamma_{NWA}|^2}{|1 - S_n \cdot \Gamma_{NWA}|^2}$$

où
$\Gamma_{NWA}$ est le facteur de réflexion d'entrée de l'analyseur de réseau.

5. Procédé de mesure du coefficient de bruit d'un objet de mesure selon l'une des revendications 1 à 4, **caractérisé en ce que** la valeur de mesure $P_{NOISE}$, à détecter sur le premier port (3) de l'analyseur de réseau (4), de la puissance de bruit de sortie présente sur le premier port (1) de l'objet de mesure (3) est calculée par division de la valeur de mesure incorrecte ($P_{Mess}$) provenant de l'analyseur de réseau (4), de la puissance de bruit de sortie présente sur le premier port (1) de l'objet de mesure (3), par une imprécision k de l'analyseur de réseau (4) détectée par le biais de l'étalonnage, selon la relation mathématique suivante :

$$P_{NOISE} = \frac{P_{Mess}}{k}$$

6. Procédé de mesure du coefficient de bruit d'un objet de mesure selon la revendication 5, **caractérisé en ce que** la valeur mesurée incorrecte $P_{MessOFF}$ sur le premier port de mesure (3) de l'analyseur de réseau (4) de la puissance de bruit de sortie présente sur le premier port (1) de l'objet de mesure (3) dans le processus d'étalonnage avec la source de bruit (6) hors circuit et connectée avec le premier port (3) de l'analyseur de réseau (4), est calculée à partir de la formule suivante :

$$P_{MessOFF} = k \cdot (N_{NWA} + N_0),$$

où

N$_0$ est le bruit thermique de la résistance de 50 $\Omega$ pour une température ambiante de 290 K et
k est l'imprécision de l'analyseur de réseau (4).

7. Procédé de mesure du coefficient de bruit d'un objet de mesure selon la revendication 6, **caractérisé en ce que** la valeur mesurée incorrecte P$_{MessON}$ sur le premier port de mesure (3) de l'analyseur de réseau (4) de la puissance de bruit de sortie présente sur le premier port (1) de l'objet de mesure (3) dans le processus d'étalonnage avec la source de bruit (6) en circuit et connectée avec le premier port (3) de l'analyseur de réseau (4), est calculée à partir de la formule suivante :

$$P_{MessON} = N_{NS} + N_{NWA} + N_0 = 10^{\frac{ENR}{10}} \cdot + N_0 + N_{NWA} + N_0,$$

où

N$_{NS}$ est le bruit additionnel de la source de bruit et
ENR est le rapport du bruit additionnel de la source de bruit avec le bruit thermique de la résistance de 50 $\Omega$ pour une température ambiante de 290 K.

8. Procédé de mesure du coefficient de bruit d'un objet de mesure selon la revendication 7, **caractérisé en ce que** l'imprécision k de l'analyseur de réseau (4) est calculée à partir de la formule suivante :

$$k = \frac{P_{MessON} - P_{MessOFF}}{10^{\frac{ENR}{10}} \cdot N_0}$$

9. Procédé de mesure du coefficient de bruit d'un objet de mesure selon la revendication 8, **caractérisé en ce que** le bruit propre N$_{NWA}$ de l'analyseur de réseau (4) est calculée à partir de la formule suivante :

$$N_{NWA} = \frac{P_{MessOFF}}{k} - N_0$$

Start

S10 — Messung der Meßwerte $P_{MessON}$ und $P_{MessOFF}$ bei ein- und ausgeschalteter, mit dem Netzwerkanalysator verbundener Rauschquelle für die Kalibrierung des Netzwerkanalysators

S20 — Ermittlung des Eigenrauschens $N_{NWA}$ und der Ungenauigkeit K des Netzwerkanalysators aus den Meßwerten $P_{MessON}$ und $P_{MessOFF}$

S30 — Messung der S-Parameter des Meßobjekts in einem Meßvorgang mit Netzwerkanalysator

S40 — Messung der Ausgangsrauschleistung an einem ersten Tor des Meßobjekts mit einem ersten Port des Netzwerkanalysators, während zweites Tor des Meßobjekts ohne Anregung mit zweiten Port des Netzwerkanalysators verbunden ist

S50 — Berechnung der Rauschzahl $F_{DUT}$ des Meßobjekts aus den jeweils gemessenen und ermittelten Meß- und Kenngrößen

Ende

# Fig. 1

Fig. 2

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10302362 A1
- WO 0025142 A
- US 5191294 A